# EUROPÄISCHE PATENTSCHRIFT

(11) **EP 0 396 099 B1**
(45) Veröffentlichungstag und Bekanntmachung des Hinweises auf die Patenterteilung: **12.10.1994**
(21) Anmeldenummer: 90108262.8
(22) Anmeldetag: 30.04.1990
(51) Int. Cl.: C23C 14/34

(54) **Anordnung zum Abtragen von Material eines Targets**
Arrangement for removal of material from a target
Dispositif pour l'enlèvement de matériau d'une cible

(30) Priorität: 02.05.1989 DE 3914476
(43) Veröffentlichungstag der Anmeldung: 07.11.1990
(73) Patentinhaber: FORSCHUNGSZENTRUM JÜLICH GMBH, 52425 Jülich (DE)
(72) Erfinder: Zander, Wilhelm-Mathias, D-5170 Jülich (DE); Fröhlingsdorf, Joachim, Dr., D-5090 Leverkusen (DE); Stritzker, Bernd, Prof. Dr., D-5172 Linnich (DE)

(56) Entgegenhaltungen:
- EP-A- 0 302 684
- US-A- 4 511 594
- US-A- 4 756 811
- Zeitschrift für Metallkunde 75 (1984) November Nr. 11 Stuttgart, Duetschland, Seiten 847-854 ; J. A. Thornton: "Hollow Cathode Magnetron Sputtering of Metallurgical Coatings"

## Beschreibung

Die Erfindung bezieht sich auf eine Anordnung zum Abtragen von Material eines Targets, bestehend aus dem Target und einem drehbaren Halter für das Target, auf welches die Strahlen eines Lasers zum Abdampfen des Targetmaterials gerichtet sind.

Eine derartige Anordnung ist beispielsweise in der Patentanmeldung DE-A-38 22 502 (P 38 22 502.6-45) beschrieben. Sie ist in einer UHV-Kammer angeordnet und dient zur Erzielung stöchiometrischer Abbildungen des Targets, d. h. zur Beschichtung von Substraten in der exakten Zusammensetzung des Targetmaterials, wobei durch die Abtragung von Targetmaterial in der UHV-Kammer ein Plasma aus dem Targetmaterial erzeugt wird. Es wird ein Excimerlaser gepulst verwendet, dessen rechteckiges Strahlprofil mit Hilfe einer Zylinderlinse zu einem Strich fokussiert wird. Damit werden hohe Abscheidungsraten bei gleichzeitig stöchiometrischer Abbildung erreicht. Das Target wird dabei gedreht und die Laserstrahlen auf die Stirnfläche des plattenförmigen Targets gerichtet. Dadurch wird zwar eine zunächst homogene Abtragung erzielt, jedoch kommt es zu einer Kraterbildung in der Targetmitte, die einerseits die Standzeit des Targets verringert, andererseits die Homogenität und Reproduzierbarkeit des Prozesses beeinträchtigt.

Es ist daher Aufgabe der Erfindung, eine Anordnung der eingangs bezeichneten Art zu schaffen, bei der die angegebenen Nachteile nicht auftreten.

Diese Aufgabe wird durch eine Anordnung mit den Merkmalen des Anspruchs 1 gelöst.

Bei der erfindungsgemäßen Anordnung wird ein zylinderförmiges bzw. walzenförmiges Target eingesetzt, das zweckmäßigerweise nicht nur um die Zylinderachse drehbar, sondern um diese Achse auch verschiebbar angeordnet ist. Das Abtragen des Targetmaterials erfolgt durch Laserstrahlen, die so fokussiert sind, daß sie in einer Linie auf den Zylindermantel auftreffen. Hierdurch wird eine gleichmäßige Ablation ohne die oben genannten Nachteile erzielt. Zur guten Ausnutzung der Anordnung wird der Laser so ausgerichtet, daß die Linie praktisch parallel zur Zylinderachse verläuft.

Bei Verfahren zur Beschichtung von Substraten hat sich gezeigt, daß die optimale Ausbildung des Plasmas in Richtung auf das zu beschichtende Substrat von dem Einfallswinkel der Strahlen auf das Target und der Lage der Auftreffstelle (der Lage der Linie auf dem Zylindermantel) abhängt. Eine entsprechende Justage der Anordnung kann dabei durch Ausrichtung der Laserstrahlen, aber auch durch seitliche Verschiebung des Targets vorgenommen werden. Es ist daher zweckmäßig, daß das Target zusätzlich seitlich verschiebbar ist. Die seitliche Verschiebung (längs der Achse des zylindrischen Targets) ergibt die Möglichkeit, bei Targets, die aus mehr als einem zylindrischen Teilstück aus jeweils unterschiedlichem Material bestehen, Mehrfachschichten herzustellen, ohne die Apparatur öffnen und das Target auswechseln zu müssen.

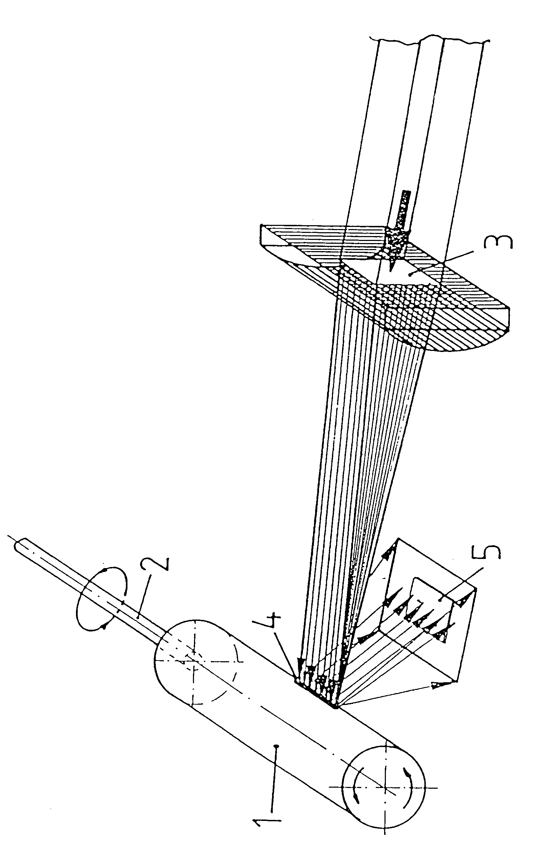

In der Zeichnung ist eine Ausführungsform der Anordnung schematisch dargestellt und wird im folgenden näher erläutert.

Das walzen- (zylinder-)förmige Target 1 (das aus mehr als einem zylindrischen Teilstück aus jeweils anderem Material bestehen kann) ist an einem Halter 2 drehbar um die Zylinderachse und längs dieser Achse verschiebbar befestigt. Mittels einer Zylinderlinse 3 werden die Laserstrahlen zu einer parallel zur Zylinderachse verlaufenden Linie 4 auf die Zylinderwandung fokussiert. Dabei wird Material vom Target abgetragen und auf einem Substrat 5 abgeschieden.

Wie aus der Zeichnung hervorgeht, liegt die Auftreffstelle der Linie 4 unterhalb der Verbindungslinie zwischen der Mitte der Zylinderlinse und der Mittelachse des Targets. Auf diese Weise wird erreicht, daß das Plasma sich in Richtung des Substrats 4 ausbildet, wodurch die Bildung der auf dem Substrat abzuscheidenden Schicht begünstigt ist.

Eine Anordnung der beschriebenen Art wurde eingesetzt zur Herstellung dünner Schichten aus Material eines oxydischen Hochtemperatur-Supraleiters aus YBa₂Cu₃O₇, wobei ein gepulster Excimerlaser (LAMBDA PHYSIK, EMG 201) eingesetzt wurde.

## Patentansprüche

1. Anordnung zum Abtragen von Material eines Targets, bestehend aus dem Target und einem drehbaren Halter für das Target, auf welches die Strahlen eines Lasers zum Abdampfen des Targetmaterials gerichtet sind,
**dadurch gekennzeichnet**,
daß das Target (1) zylinderförmig ist und mittels des Halters (2) um die Zylinderachse drehbar ist und die Strahlen des Lasers auf den Zylindermantel gerichtet sind.

2. Anordnung nach Anspruch 1,
**dadurch gekennzeichnet**,
daß das Target (1) längs der Zylinderachse verschiebbar ist.

3. Anordnung nach Anspruch 1 oder 2,
**dadurch gekennzeichnet**,
daß die Laserstrahlen so fokussiert sind, daß sie in einer Linie (4) auf den Zylindermantel auftreffen.

4. Anordnung nach Anspruch 3,
**dadurch gekennzeichnet**,
daß die Linie (4) parallel zur Zylinderachse verläuft.

5. Anordnung nach einem der vorangehenden Ansprüche,
**dadurch gekennzeichnet**,
daß das Target (1) seitlich verschiebbar ist.

## Claims

1. An arrangement for removing material from a target, consisting of the target and a rotatable holder for the target on to which the rays of a laser are directed for the volatilisation of the target material, characterised in that the target (1) is cylindrical and can be rotated about the axis of the cylinder by means of the holder (2), and the rays of the laser are directed on to the curved surface of the cylinder.

2. An arrangement according to claim 1, characterised in that the target (1) can be displaced along the axis of the cylinder.

3. An arrangement according to claim 1 or 2, characterised in that the laser rays are focused so that they impinge on the curved surface of the cylinder in a line (4).

4. An arrangement according to claim 3, characterised in that the line (4) runs parallel to the axis of the cylinder.

5. An arrangement according to any one of the preceding claims, characterised in that the target (1) is laterally displaceable.

## Revendications

1. Dispositif pour l'enlèvement de matériau d'une cible, constitué de la cible et d'un support rotatif pour la cible, sur laquelle sont dirigés les rayons d'un laser afin de volatiliser le matériau de la cible, **caractérisé** en ce que la cible (1) est cylindrique et peut être tournée autour de l'axe du cylindre au moyen du support (2), et les rayons du laser sont dirigés sur la face d'enveloppe du cylindre.

2. Dispositif selon la revendication 1, **caractérisé** en ce que la cible (1) peut être déplacée le long de l'axe du cylindre.

3. Dispositif selon la revendication 1 ou 2, **caractérisé** en ce que les rayons laser sont focalisés de telle sorte qu'ils atteignent la face d'enveloppe du cylindre sur une ligne (4).

4. Dispositif selon la revendication 3, **caractérisé** en ce que la ligne (4) s'étend parallèlement à l'axe du cylindre.

5. Dispositif selon l'une quelconque des revendications précédentes, **caractérisé** en ce que la cible (1) peut être déplacée latéralement.
